Europäisches Patentamt

(19) European Patent Office

Office européen des brevets

(11) Numéro de publication: **0 251 889**
**B1**

(12) **FASCICULE DE BREVET EUROPEEN**

(45) Date de publication du fascicule du brevet: **10.10.90**

(21) Numéro de dépôt: **87401432.7**

(22) Date de dépôt: **23.06.87**

(51) Int. Cl.⁵: **G11C 16/02, G11C 17/00**

(54) **Procédé de programmation de données dans une mémoire morte programmable électriquement.**

(30) Priorité: **27.06.86 FR 8609355**

(43) Date de publication de la demande:
**07.01.88 Bulletin 88/1**

(45) Mention de la délivrance du brevet:
**10.10.90 Bulletin 90/41**

(84) Etats contractants désignés:
**CH DE ES FR GB IT LI NL**

(56) Documents cités:
**US-A- 4 173 791**

**NEW ELECTRONICS,**
**vol. 15, no. 3, février 1982, pages 46-50, Londres, GB; P.**
**HAROLD: "Production e.p.r.o.m. loading"**

(73) Titulaire: **SGS-THOMSON MICROELECTRONICS S.A., 7,**
**Avenue Galliéni, F-94250 Gentilly(FR)**

(72) Inventeur: **Lisimaque, Gilles, Thomson-CSF**
**SCPI 19, Avenue Messine, 75008 Paris(FR)**

(74) Mandataire: **Ballot, Paul Denis Jacques et al, Cabinet**
**Ballot-Schmit 7, rue le Sueur, F-75116 Paris(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

## Description

La présente invention concerne la programmation de données dans une mémoire morte programmable électriquement faisant partie d'un circuit intégré.

L'application plus particulièrement envisagée est celle des "cartes à mémoire", c'est-à-dire des cartes comportant un circuit intégré avec une mémoire morte électriquement programmable.

Par mémoire morte programmable électriquement on entendra une mémoire dans laquelle on peut inscrire des données par application de signaux électriques appropriés sur les entrées du circuit intégré comportant la mémoire, ces données restant alors inscrites en mémoire même en l'absence d'alimentation électrique pendant une longue durée, appelée durée de rétention ; cette durée peut atteindre plusieurs années.

Dans beaucoup d'applications envisagées pour les cartes à mémoire, les cartes doivent être produites à un très grand nombre d'exemplaires, et les données à inscrire sur chaque carte peuvent comprendre un grand nombre de bits, par exemple 8 kilobits.

Or la programmation de chaque bit, ou de chaque octet si la programmation se fait octet par octet, dure un temps qui, même s'il est court, n'est pas négligeable.

A titre indicatif, on a considéré d'abord que la programmation d'un octet devait se faire par application d'une tension de programmation Vpp pendant une durée de 50 millisecondes qui est en fait très supérieure à ce qui est nécessaire mais qui inclut une marge de sécurité permettant d'être sûr qu'on obtienne une durée de rétention de 10 ans.

Pour réduire la durée de programmation, on a proposé de vérifier immédiatement après l'écriture que les transistors constituant la mémoire ont reçu une charge électrique suffisante pour assurer la durée de rétention. Cette vérification permet de se dispenser d'appliquer une tension de programmation avec une marge de sécurité très importante comme on le faisait avant. Pratiquement, on peut programmer pendant 2 millisecondes, lire le résultat (quelques microsecondes), recommencer si le résultat est mauvais, et programmer à nouveau par sécurité pendant 4 millisecondes si le résultat est bon.

Toutefois, ce cycle de programmation est encore trop long lorsqu'on doit programmer des millions de cartes : pour le fabricant qui programme les cartes, la durée est prohibitive.

C'est pourquoi, on a pensé que l'on pouvait rejeter vers l'utilisateur (au lieu du fabricant) les tâches de programmation. Chaque utilisateur ayant un nombre plus restreint de cartes à programmer, le problème de la durée est moins critique.

Toutefois cette solution n'est pas envisageable dans certains cas où les informations à inscrire sont de nature confidentielle et doivent impérativement être inscrites par le fabricant : par exemple l'information concerne l'identification de l'utilisateur et ne doit pas être inscrite par l'utilisateur lui-même.

Pour résoudre le problème de la durée de programmation l'invention propose une solution simple qui consiste à programmer en deux temps : dans une première phase le fabricant programme les données pendant une durée faible mais suffisante pour conserver une rétention des informations jusqu'au moment de la deuxième phase de la programmation ; lors de la deuxième phase, qui a lieu chez l'utilisateur plutôt que chez le fabricant, on reprogramme la mémoire, non pas à partir de données appliquées à nouveau à l'entrée du circuit intégré incorporant la mémoire, mais à partir des données déjà présentes dans la mémoire et sans rendre ces données accessibles en lecture de l'extérieur du circuit intégré et sans permettre leur modification par l'extérieur. Cette deuxième phase est exécutée avec une durée de programmation aussi longue qu'il est nécessaire pour obtenir la rétention finale désirée (par exemple 10 ans).

Plus précisément, l'invention propose un procédé de programmation d'une mémoire morte électriquement programmable faisant partie d'un circuit intégré, ce procédé étant caractérisé en ce qu'il comprend les deux étapes principales suivantes :

1) dans une première étape on applique sur des entrées du circuit intégré des données à écrire dans la mémoire et on effectue la programmation de chaque donnée en appliquant une tension de programmation pendant une durée beaucoup plus courte que celle qu'il faudrait prévoir pour assurer la durée de rétention finale désirée pour ces données, mais qui est quand même suffisante pour assurer une rétention des données jusqu'à la deuxième étape,

2) dans une deuxième étape, on reprogramme systèmatiquement chacune des données en appliquant une tension de programmation pendant une durée suffisante pour obtenir la durée de rétention finale désirée, cette reprogrammation étant effectuée par un moyen de programmation interne au circuit intégré, qui lit les données dans la mémoire et les réinscrit, sans que les données soient à nouveau appliquées aux entrées du circuit intégré, ni à partir de l'extérieur du circuit ni à partir de l'intérieur.

Le procédé selon l'invention n'est pas spécifique d'un type de mémoire particulier ou d'un type de circuit intégré particulier ; simplement, il concerne les mémoires non volatiles dont la durée de rétention d'informations peut être augmentée (au moins dans une certaine plage) par un accroissement de la durée d'application d'une tension de programmation Vpp.

C'est le cas de la plupart des mémoires non volatiles dans lesquelles l'information est stockée sous forme de charges électriques piégées localement, par exemple piégées dans une grille flottante ou à un interface entre deux couches isolantes.

Dans un exemple de réalisation, le circuit intégré est constitué essentiellement par une mémoire morte programmable associée à un petit nombre de circuits spécifiques (comparateurs, compteurs, additionneurs etc...) de traitement de données.

Dans ce cas, pour la mise en oeuvre de l'invention, on prévoit dans le circuit intégré un automate d'écriture dont la fonction est de réaliser la deuxième partie de la programmation. Cet automate lit successivement chaque donnée de la mémoire, bit par bit ou mot par mot, et réinscrit au même emplacement la donnée lue, sans en changer la valeur. L'activation de cet automate d'écriture est déclenchée par exemple par l'extérieur du circuit intégé, mais le couplage entre l'automate de lecture et la mémoire pendant la lecture et la réécriture se fait sans que les données lues et réécrites se présentent sur les bornes extérieures du circuit.

Dans un autre exemple de réalisation, le circuit intégré comprend un microprocesseur, c'est-à-dire un circuit capable d'exécuter de nombreuses fonctions différentes définies par des instructions reçues sous forme de signaux logiques. Les séquences d'instructions reçues définissent une succession de tâches exécutées successivement par le microprocesseur. Ces séquences sont par exemple stockées dans une mémoire morte de programmes (programmée par masque le plus souvent). Parmi les instructions possibles, les microprocesseurs possèdent toujours des instructions de lecture ou d'écriture dans des mémoires.

Dans ce cas on prévoit que sont stockées dans la mémoire morte de programmes une séquence d'instructions de lecture et de réécriture, donnée par donnée, dans la mémoire morte programmable électriquement, cette séquence étant déclenchée par une instruction appropriée fournie au microprocesseur à partir des bornes extérieures du circuit intégré. Là encore, durant l'exécution de cette séquence, les données lues puis réinscrites en mémoire par le microprocesseur restent à l'intérieur du circuit intégré et ne se présentent pas sur les bornes extérieures ; un bus interne de données isolé des bornes extérieures pendant l'exécution de cette séquence, est donc prévu entre le microprocesseur et la mémoire programmable électriquement.

Que le circuit intégré comprenne ou non un microprocesseur, on peut prévoir soit des moyens de déclenchement automatique de la deuxième phase de programmation, soit un déclenchement commandé par un signal appliqué à une borne extérieure du circuit intégré (ou plusieurs signaux constituant une instruction pour le microprocesseur).

Par exemple, si le circuit intégré est incorporé à une carte de transactions monétaires, le lecteur de carte peut fournir les signaux de déclenchement appropriés lors d'une revalorisation de la carte par une banque.

Ou encore, si la mémoire comporte un bit témoin conçu pour avoir une durée de rétention d'information plus faible que celle des autres bits de la mémoire, la disparition de la programmation de ce bit témoin peut servir à déclencher la deuxième étape de programmation.

## Revendications

Procédé de programmation d'une mémoire morte électriquement programmable faisant partie d'un circuit intégré, caractérisé en ce qu'il comprend les deux étapes principales suivantes :

1) dans une première étape on applique sur des entrées du circuit intégré des données à inscrire dans la mémoire, et on effectue la programmation de chaque donnée en appliquant une tension de programmation pendant une durée beaucoup plus courte que celle qui est théoriquement nécessaire pour assurer la durée de rétention finale désirée pour ces données mais qui est suffisante pour assurer une rétention des données jusqu'à la deuxième étape,

2) dans une seconde étape, on reprogramme systématiquement chacune des données en appliquant une tension de programmation pendant une durée suffisante pour obtenir la durée de rétention finale désirée, cette deuxième programmation étant effectuée par un moyen de programmation interne au circuit intégré qui lit les données dans la mémoire et les réinscrit sans que les données soient appliquées aux entrées du circuit intégré ni à partir de l'extérieur du circuit ni à partir de l'intérieur.

## Claims

A method for programming of an electrically programmable read only memory forming a part of an integrated circuit, characterized in that it comprises the main two following stages:

(1) in a first stage data to be written in the memory are applied to inputs of the integrated circuit, and the programming of each item of data is performed by applying a programming voltage during a time very much shorter than the theoretically necessary time in order to ensure the duration of final retention desired for such data but sufficient in order to ensure retention of the data until the second stage, and

(2) in a second stage each of the data items is systematically reprogrammed by applying a programming voltage for a sufficient duration in order to obtain the final desired retention duration, said second programming operation being performed by means of internal programming of the integrated circuit which reads data in the memory and rewrites them without the data being applied to the inputs of the integrated circuit either from the outside of the circuit or from the interior.

## Patentansprüche

Verfahren zur Programmierung eines zu einer integrierten Schaltung gehörenden elektrisch programmierbaren Festwertspeichers, dadurch gekennzeichnet, daß es die beiden folgenden wesentlichen Schritte umfaßt:

1) in einem ersten Schritt werden an die Eingänge der integrierten Schaltung in den Speicher einzuschreibende Daten gegeben und die Programmierung sämtlicher Daten dadurch bewerkstelligt, daß während einer Dauer, die sehr viel kürzer ist als diejenige, die theoretisch zum Sichern der für diese Daten gewünschten endgültigen Haltedauer notwendig ist, die aber ausreicht, um ein Halten der Daten bis zum zweiten Schritt zu gewährleisten, eine Programmierspannung angelegt wird,

2) in einem zweiten Schritt werden sämtliche Daten dadurch systematisch neuprogrammiert, daß während einer Dauer, die ausreicht, um die gewünschte endgültige Haltedauer zu erzielen, eine Programmierspannung angelegt wird, wobei diese zweite Programmierung durch ein internes Programmiermittel der integrierten Schaltung bewerkstelligt wird, das die Daten im Speicher liest und sie neu einschreibt, ohne daß die Daten weder von außerhalb der integrierten Schaltung noch von innen an die Eingänge der Schaltung gegeben werden.